Europäisches Patentamt

European Patent Office

Office européen des brevets

(19)

(11) Veröffentlichungsnummer : **0 349 078 B1**

(12)

# EUROPÄISCHE PATENTSCHRIFT

(45) Veröffentlichungstag der Patentschrift :
**01.03.95 Patentblatt 95/09**

(51) Int. Cl.$^6$ : **G01R 33/54**

(21) Anmeldenummer : **89201679.1**

(22) Anmeldetag : **26.06.89**

(54) **Schaltungsanordnung zur Erzeugung von Hochfrequenzsignalen für Kernspinuntersuchungen.**

(30) Priorität : **30.06.88 DE 3821984**

(43) Veröffentlichungstag der Anmeldung :
**03.01.90 Patentblatt 90/01**

(45) Bekanntmachung des Hinweises auf die
Patenterteilung :
**01.03.95 Patentblatt 95/09**

(84) Benannte Vertragsstaaten :
**DE FR GB NL**

(56) Entgegenhaltungen :
**EP-A- 0 165 057**
**EP-A- 0 292 064**
**US-A- 4 694 254**
**REVIEW OF SCIENTIFIC INSTRUMENTS,**
**Band 46, Nr. 8, August 1975, Seiten 1051-1053;**
**J.L. ACKERMAN et al.: "Device for rapid mani-**
**pulation of frequencies in NMR"**

(73) Patentinhaber : **Philips Patentverwaltung**
**GmbH**
**Wendenstrasse 35c**
**D-20097 Hamburg (DE)**
(84) **DE**
Patentinhaber : **Philips Electronics N.V.**
**Groenewoudseweg 1**
**NL-5621 BA Eindhoven (NL)**
(84) **FR GB NL**

(72) Erfinder : **Proksa, Roland**
**Ophagen 12**
**D-2000 Hamburg 20 (DE)**
Erfinder : **Röschmann, Peter**
**Steenbalken 13**
**D-2000 Hamburg 63 (DE)**
Erfinder : **van den Berg, Noel**
**Hogebergdreef 58**
**NL-4645 EX Putte (NL)**

(74) Vertreter : **Hartmann, Heinrich, Dipl.-Ing. et al**
**Philips Patentverwaltung GmbH,**
**Wendenstrasse 35c**
**D-20097 Hamburg (DE)**

EP 0 349 078 B1

## Beschreibung

Die Erfindung betrifft eine Schaltungsanordnung nach dem Oberbegriff des Anspruchs 1. Eine solche Schaltungsanordnung ist im wesentlichen aus der Zeitschrift "Neues aus der Technik", Nr. 1 vom 15. Febr. 1984, Seite 4, beitrag 771 bekannt.

Derartige Schaltungsanordnungen dienen zur Erzeugung von Hochfrequenzimpulsen bei Kernspinuntersuchungen, beispielsweise in der sogenannten MR-Tomographie. Dabei wird eine Hochfrequenzschwingung für einige ms eingeschaltet, wobei die Frequenz die Phase oder die Amplitude dieser Hochfrequenzschwingung moduliert sein kann. Die Frequenz dieser Schwingung ist durch die Larmorfrequenz vorgegeben, die ihrerseits durch die Flußdichte des stationären Magnetfeldes bestimmt wird, das in dem Kernspinuntersuchungsgerät erzeugt wird.

Bei der bekannten Schaltungsanordnung ist der Verlauf des gesamten Hochfrequenzimpulses in einem schnellen Digitalspeicher gespeichert. Ein solcher Speicher muß, wenn er als Festwertspeicher ausgebildet ist, eine sehr hohe Speicherkapazität haben, insbesondere wenn man bedenkt, daß mit einem Kernspinuntersuchungsgerät eine Vielzahl von Hochfrequenzimpulsen mit unterschiedlichem zeitlichen Verlauf erzeugt werden muß.

Weiterhin ist aus der Zeitschrift Rev. Sci. Instrum. Vol. 46, Nr. 8, Aug. 1975, Seiten 1051 - 1053 eine Schaltungsanordnung der eingangs genannten Art bekannt, bei der in dem Festwertspeicher. nur einer Viertelperiode einer sinusförmigen Schwingung gespeichert ist. Die dafür erforderliche Speicherkapazität kann vergleichsweise klein sein. Allerdings ergeben sich auch hierbei Anforderungen an den Digital-Analog-Wandler, die bei höheren Frequenzen kaum zu erfüllen sind.

Ein Analog-Digital-Wandler wird üblicherweise mit einer Taktfrequenz betrieben, die mindestens doppelt so groß ist wie die Frequenz des von ihm zu erzeugenden analogen Signals. Dessen Frequenz, die sogenannte Larmor-Frequenz, liegt aber auch bei Kernspinuntersuchungsgeräten mit einem stationären Magnetfeld von nur 0,15 T bei mehr als 5 MHz, so daß die Taktfrequenz des Digital-Analog-Wandlers oberhalb von 10 MHz liegen müßte. Bei Kernspinuntersuchungsgeräten mit einem stärkeren Magnetfeld muß die Taktfrequenz für den Digital-Analog-Wandler entsprechend höher liegen. - Darüberhinaus wird von einem solchen Wandler ein hohes Auflösungsvermögen gefordert. Diese Forderungen sind nur zu erfüllen, wenn er Datenworte mit einer Wortbreite von wenigstens 12 Bit verarbeiten kann. Ein Digital-Analog-Wandler für Taktfrequenzen von mehr als 10 MHz und Datenwortbreite von wenigstens 12 Bit ist aber - wenn überhaupt - allenfalls mit großem Aufwand realisierbar.

Es ist Aufgabe der vorliegenden Erfindung, eine Schaltungsanordnung der eingangs genannten Art so auszugestalten, daß die Anforderungen an den Digital-Analog-Wandler verringert werden können. Diese Aufgabe wird erfindungsgemäß durch die im Hauptanspruch angegebenen Maßnahmen gelöst.

Bei der Erfindung wird die Tatsache ausgenutzt, daß ein sinusförmiges Digitalsignal am Ausgang eines Digital-Analog-Wandlers ein Spektrum erzeugt, das neben einer Linie mit der gleichen Frequenz wie das Digitalsignal Seitenlinien zu der Taktfrequenz bzw. deren Harmonischen erzeugt, deren Frequenzabstand von der Taktfrequenz bzw. deren Harmonischen der Frequenz des Digitalsignals entspricht. Auf diese Weise ist es möglich, Hochfrequenzsignale mit einer Frequenz oberhalb der Taktfrequenz des Digital-Analog-Wandlers zu erzeugen. Es ist dabei nicht mehr erforderlich, die Signalfrequenz im analogen Verarbeitungsteil auf einen höheren Wert zu transponieren.

In weiterer Ausgestaltung der Erfindung ist vorgesehen, daß die Taktfrequenz $f_T$ und die Frequenz $f_s$ des aus dem Festwertspeicher ausgelesenen Signals so gewählt sind, daß die Beziehung gilt:

$$f_L = nf_T + af_s,$$

n eine positive ganze Zahl größer als Null ist und wobei a den Wert +1 oder -1 hat.

Bei Kernspinuntersuchungen ist es erwünscht, die Frequenz der Hochfrequenzimpulse um Beträge zu ändern, die bei 1Hz oder gar darunter liegen. Bezogen auf die Larmor-Frequenz, die mindestens einige MHz beträgt, ist dies eine Frequenzänderung von $10^{-7}$. Eine solche Frequenzauflösung kann erreicht werden, wenn der Festwertspeicher eine Speicherkapazität von z.B. 16 MWorten hat.

Zur Verringerung der Anforderungen an die Speicherkapazität des Festwertspeichers ist in weiterer Ausgestaltung der Erfindung vorgesehen, daß der Adressengenerator eine Zählanordnung enthält, deren Zählstand mit der Taktfrequenz jeweils um einen vorgebbaren Betrag änderbar ist, daß die Zählkapazität der Zählanordnung mehrfach so groß ist, wie die Zahl der adressierbaren Speicherplätze im Festwertspeicher und daß das Adreßsignal für den Festwertspeicher aus den höherwertigen Binärstellen des Ausgangssignals der Zählanordnung abgeleitet wird. Das Frequenzauflösungsvermögen wird hierbei durch die Wortbreite bestimmt, mit der die Zählanordnung arbeitet. Ist diese Zählanordnung also für eine Wortbreite von 24 Bit ausgelegt, dann läßt sich die gewünschte Frequenzauflösung auch mit einem Speicher mit einer Speicherkapazität von 64 kWorte erreichen, zu dessen Adressierung nur die 16 höchstwertigen Bit des Ausgangssignals der Zählanordnung erforderlich sind.

Bei verschiedenen Kernspinuntersuchungen ist eine phasenkohärente Frequenzänderung erforderlich. Das bedeutet, daß, wenn im Rahmen einer Kernspinuntersuchung die Frequenz des Hochfrequenzsignals auf einen anderen Wert umgeschaltet und danach wieder auf den ursprünglichen Wert zurückgeschaltet wird, seine Phase den Wert annehmen muß, den sie hätte, wenn die Hin- und Herschaltung der Frequenz unterblieben wäre.

Eine Weiterbildung der Erfindung sieht daher vor, daß der Adressengenerator eine Zählanordnung enthält, deren Zählstand mit der Taktfrequenz um einen vorgebbaren Betrag änderbar ist und daß zwischen der Zählanordnung und dem Festwertspeicher eine Multiplizierschaltung vorgesehen ist, in der der Zählstand jeweils mit einem vorgebbaren Faktor multipliziert wird. Bei dieser Ausgestaltung ist der Zählstand unabhängig von der Frequenz, so daß die durch den Zählstand bestimmte Phase durch eine Frequenzänderung nicht beeinflußt wird.

Die Erfindung wird nachstehend anhand der Zeichnungen näher erläutert. Es zeigen:

Fig. 1 einen Kernspintomographen, bei dem die Erfindung einsetzbar ist,

Fig. 2 das Blockschaltbild einer erfindungsgemäßen Schaltung,

Fig. 3 das Blockschaltbild eines dafür geeigneten Adressengenerators,

Fig. 4 den zeitlichen Verlauf des Ausgangssignals des Digital-Analog-Wandlers und

Fig. 5 das Spektrum am Ausgang des Digital-Analog-Wandlers.

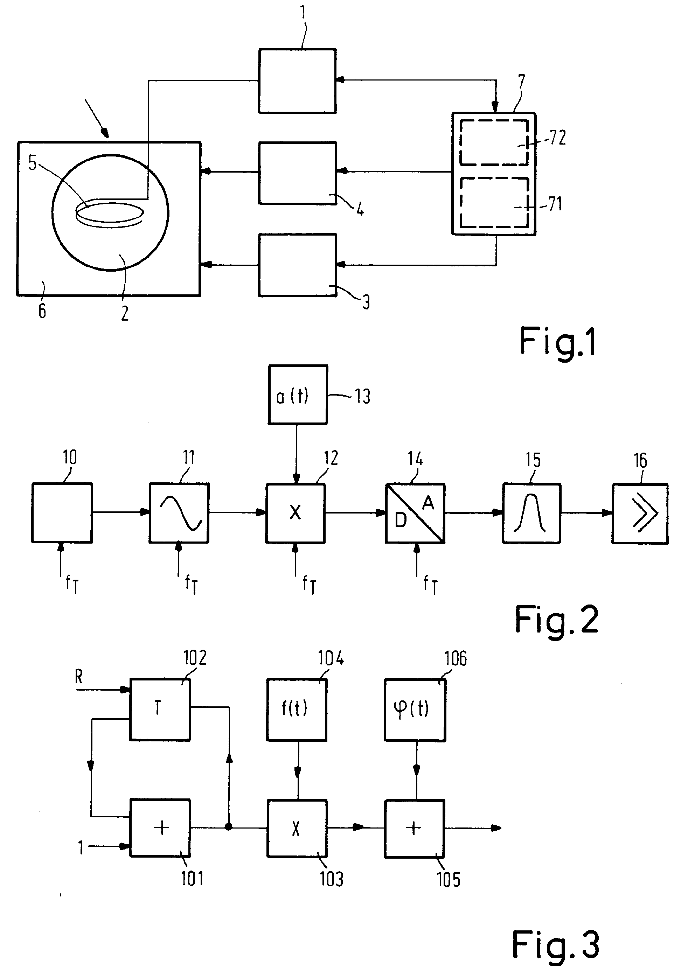

In Fig. 1 ist mit 6 eine Vorrichtung bezeichnet, die in einem Untersuchungsbereich 2 ein zur Zeichenebene senkrecht verlaufendes homogenes stationäres Magnetfeld von z.B. 0,16 T erzeugt und die bei Bedarf auch magnetische Gradientenfelder erzeugt, d.h. Magnetfelder, die in der gleichen Richtung verlaufen wie das stationäre homogene Magnetfeld, deren Stärke sich jedoch linear in Richtung des Magnetfeldes oder in einer dazu senkrechten Richtung ändert. Die Vorrichtung 6 ist zu diesem Zweck mit einem Generator 3 gekoppelt, der das stationäre Magnetfeld erzeugt, und mit einem Generator 4, der die Ströme für die verschiedenen magnetischen Gradientenfelder liefert.

Außerdem ist eine Hochfrequenzspule 5 vorgesehen, die ein zum stationären Feld senkrechtes hochfrequentes Magnetfeld erzeugt und die an den Ausgang eines Spektrometers 1 angeschlossen ist. Das Spektrometer umfaßt einen Sendeteil, in dem die Hochfrequenzsignale für die Kernspinuntersuchungen erzeugt werden und einen Empfangsteil, in dem die im Untersuchungsbereich entstehenden Kernresonanzsignale empfangen und verarbeitet werden. Bei der angegebenen Feldstärke von 0,16 T liegt die Frequenz der von Sendeteil erzeugten Hochfrequenzsignale und der im Untersuchungsbereich entstehenden Kernresonanzsignale bei 6,8 MHz.

Die Generatoren 3 und 4 und das Spektrometer 1 werden durch eine digitale Zentraleinheit 7 gesteuert, die zu diesem Zweck einen Steuerteil 71 enthält. Außerdem umfaßt die digitale Zentraleinheit einen Verarbeitungsteil 72, der die vom Spektrometer 1 gelieferten Daten verarbeitet und daraus die Kernmagnetisierungsverteilung im Untersuchungsbereich 2 rekonstruiert.

Fig. 2 zeigt ein Blockschaltbild des Sendeteils des Spektrometers 1. In Fig. 2 ist mit 10 ein Adressengenerator bezeichnet, der - getaktet mit einer Taktfrequenz $f_T$ -eine linear ansteigende Zahlenfolge erzeugt. Nach Erreichen eines Maximalwertes springt das Ausgangssignal auf einen Anfangswert zurück, um danach wiederum bis zum maximalen Wert linear anzusteigen usw. Der Adressengenerator 10 liefert also ein sägezahnförmiges digitales Signal.

16 Binärstellen dieses sägezahnförmigen Signals dienen als Adresse für einen Festwertspeicher 11 (PROM), in dem ein sinusförmiges Signal gespeichert ist und der eine Speicherkapazität von $2^{16}$ Datenworten mit einer Wortbreite von jeweils 16 Bit besitzt. Zwischen dem Adreßsignal x am Eingang des Festwertspeichers 11 und seinem Ausgangssignal y besteht die Beziehung:

$$y = Int (c . sin(x/b))$$

Dabei bezeichnet Int ( ) den gerundeten ganzzahligen Teil des Klammerausdrucks, c den Maximalwert, der in dem Speicher 11 gespeichert sein kann ($2^{16}$) und b eine Konstante, die um den Faktor 6,283.. kleiner ist als c. Somit wird durch den Festwertspeicher das periodische sägezahnförmige Digitalsignal an seinem Eingang in ein periodisches sinusförmiges Digitalsignal umgesetzt.

Es ist nicht erforderlich, daß in dem Speicher der Verlauf einer vollständigen Sinusschwingung gespeichert ist; es genügt vielmehr, wenn nur eine Viertel-Periode einer solchen Sinusschwingung gespeichert ist. In Abhängigkeit von den beiden höchstwertigen Bits am Adresseneingang des Speichers wird dabei die gespeicherte Viertel-Periode der Sinusschwingung auf- oder absteigend mit positiven oder negativen Vorzeichen durchlaufen. Der Speicherbedarf ist in diesem Fall auf ein Viertel reduziert, jedoch müssen in Abhängigkeit von den beiden höchstwertigen Bits die Reihenfolge des Aufrufs umgekehrt und/oder die Polarität gewechselt werden.

Frequenz- und Phase des auf diese weise erzeugten sinusförmigen Ausgangssignals des Festwertspeichers 11 sind vorgebbar, weil die Frequenz und die Phase des vom Adressengenerator 10 erzeugten Adreßsignals vorgebbar sind.

Dies wird anhand von Fig. 3 erläutert, die ein Blockschaltbild des Adressengenerators 10 darstellt.

Wie aus Fig. 3 ersichtlich, enthält der Adressengenerator u.a. eine Zählanordnung, die aus einer Addierschaltung 101 und einem Register 102 besteht, die für eine Wortbreite von jeweils 24 Bit ausgelegt sind. Der Ausgang der Addierschaltung 101 ist über das Register 102 auf einen ihrer Addiereingänge rückgekoppelt. An einem zweiten Addiereingang liegt ein konstanter Wert, vorzugsweise der Wert 1 an. Somit erhöht sich der Zählerstand mit jedem Takt der Taktfrequenz $f_T$ um 1. Durch einen Impuls auf den Rückstelleingang R des Registers 102 kann der Zählvorgang in einer definierten Phasenlage gestartet werden.

Das Ausgangssignal der Addierschaltung 101 wird einer Multiplizierstufe 103 zugeführt, in der es mit einem Faktor multipliziert wird, der von einer Schaltung 104 geliefert wird und ebenfalls 24 Bit breit sein kann. Die Frequenz des sägezahnförmigen Signals bzw. des sinusförmigen Signals ist dem von der Schaltung 104 gelieferten Faktor direkt proportional. Wenn dieser Faktor etwa 6 040 000 beträgt, dann hat das sägezahnförmige Signal eine Frequenz von etwa 1,8 MHz. Eine Änderung des Faktors um den Betrag 1 hat eine Frequenzänderung um 0,298 Hz zur Folge.

Bei verschiedenen Kernspinuntersuchungsverfahren wird mit frequenzmodulierten Hochfrequenzimpulsen gearbeitet. In diesem Fall darf der von der Schaltung 104 gelieferte Faktor nicht konstant sein, sondern muß sich in gleicher Weise ändern, wie sich die gewünschte Frequenz ändern soll. Zu diesem Zweck kann die Schaltung 104 einen Speicher enthalten, in dem der gewünschte Frequenzverlauf als Folge von Datenworten gespeichert ist. Da die Frequenzänderung einer frequenzmodulierten Schwingung für Kernspinuntersuchungen klein im Vergleich zur Larmor-Frequenz ist, kann der hierfür erforderliche Speicher eine relativ geringe Speicherkapazität haben.

Von den 48 Bit, die das Ergebnis der Multiplikation bilden, werden nur 16 Bit weiterverarbeitet und zwar von den 24 Binärstellen mit der niedrigsten Wertigkeit die 16 höchstwertigen. Diese werden einer Addierschaltung 105 zugeführt, in der zu dem Ausgangssignal 103 ein konstanter Wert addiert wird, der die Phase des sägezahnförmigen Signals und damit auch des sinusförmigen Signals am Ausgang des Festwertspeichers 11 festlegt. Zur Erzeugung eines phasenmodulierten Signals kann dieser Summand gegebenenfalls ebenfalls zeitlich veränderbar sein. Obwohl der Speicher 11 nur $2^{16}$ Speicherplätze aufweist, ist die Frequenzauflösung durch die Wortbreite der Zählanordnung gegeben; sie beträgt $2^{-24} f_T$.

Die einzelnen Komponenten des Adressengenerators 10, aber auch die anderen digitalen Schaltungen im Blockschaltbild der Figur 2 verarbeiten die Digitalsignale in einer Zeit, die gegenüber der Taktzeit (200 ns) nicht mehr vernachlässigbar ist. Es ist deshalb zweckmäßig, diesen Komponenten, zu denen insbesondere der Multiplizierer 103 gehört, einen Zwischenspeicher nachzuschalten, so daß die nachfolgende Schaltung ihre Eingangsgröße aus dem Zwischenspeicher entnimmt. Diese Zwischenspeicher sind in den Figuren 2 und 3 der Übersichtlichkeit halber nicht dargestellt.

Weil von dem Ergebnis der Multiplizierschaltung 103 nur 16 Binärstellen den Festwertspeicher 11 beeinflussen, kann eine Vielzahl von Zählständen der Zählanordnung 101, 102 jeweils einer einzigen Adresse des Festwertspeichers 11 zugeordnet sein; außerdem wird der Adressenraum in der Regel mit unterschiedlichen Anfangs- und Endadressen durchlaufen. Dies hat zur Folge, daß eine Periode des Ausgangssignals wesentlich größer ist als das Doppelte des Zeitraums zwischen zwei Nullstellen. Diese vergrößerte Periodizität hat eine positive Auswirkung, weil sich dadurch die durch die endliche Rechengenauigkeit erzeugten Störanteile über ein breiteres Band des Spektrums verteilen. Das bedeutet, daß die sich durch die Diskretisierung ergebende Störfrequenzen eine geringere Intensität bekommen und teilweise im breitbandigen Rauschen verschwinden.

Das digitale sinusförmige Ausgangssignal des Festwertspeichers 11 wird einer weiteren Multiplizierschaltung 12 zugeführt, in der es mit einem Faktor multipliziert wird, der einem Wellenformgenerator 13 entnommen wird. Dieser Faktor bestimmt die Amplitude des Signals. Da bei amplitudenmodulierten Signalen dieser Faktor nicht konstant ist, wird die Wellenform bzw. die Umhüllende des Signals vorzugsweise eine in dem Wellenformgenerator 13 enthaltenen Speicher als Folge von Datenworten entnommen. Die zwölf höchstwertigen Binärstellen des Ausgangssignals der Multiplizierschaltung 12 werden einem 12-Bit-Digital-Analog-Wandler 14 zugeführt, der das an seinem Eingang als Folge von Datenworten anliegende digitale Signal in ein analoges Signal umsetzt.

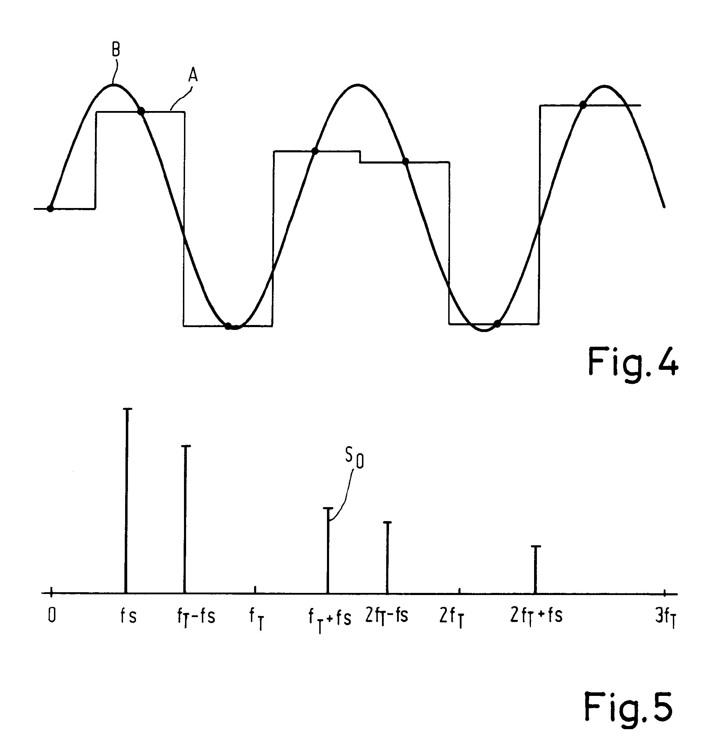

Fig. 4 zeigt das resultierende Analogsignal A. Man erkennt, daß das sinusförmige Signal durch nur relativ wenig Stützstellen angenähert wird (bei einer Taktfrequenz $f_T$ von 5 MHz und einer Signalfrequenz $f_s$ von 1,8 MHz gibt es in zeitlichen Mittel 2,78 Stützstellen pro Schwingung). Im Vergleich dazu ist mit B das sinusförmige Signal bezeichnet, das sich ergeben würde, wenn die Stützstellen unendlich dicht aufeinander folgen würden. Man erkennt, daß das sinusförmige Signal B das treppenförmige Signal A immer in der Mitte einer Stufe schneidet, und man erkennt deutlich, daß eine Periode des Signals A nicht mit einer Periode des Signals B identisch ist (sondern wesentlich größer ist wie zuvor schon dargelegt).

Das Spektrum des Ausgangssignals A des Digital-Analog-Wandlers 14 ist in Figur 5 dargestellt. Dieses Spektrum zeigt zunächst eine Linie bei der Frequenz $f_s$. Das ist die Frequenz des sinusförmigen Signals B bzw. die Frequenz, mit der der Adressengenerator 10 die Adressen des Festwertspeichers 11 durchläuft. Daneben gibt es beiderseits der Taktfrequenz $f_T$ und deren höheren Harmonischen noch Seitenlinien, deren Frequenzabstand von der Taktfrequenz bzw. deren Harmonischen der Frequenz $f_s$ entspricht. Die obere Seitenline $S_o$ der Taktfrequenz hat

dabei eine Frequenz $f_T + f_s$ (6,8 MHz), die der Larmor-Frequenz eines Kernspinuntersuchungsgerätes mit einem Magnetfeld von 0,16 T entspricht.

Man erkennt aus den Figuren 4 und 5, daß die Frequenz $f_s$ kleiner sein muß als die Hälfte der Taktfrequenz (im Beispiel also kleiner als 2,5 MHz), damit jede Sinusschwingung durch wenigstens zwei Stützstellen wiedergegeben wird. Auf der anderen Seite nimmt die Amplitude der Seitenlinien mit zunehmender Frequenz ab.

Der im Ausführungsbeispiel gewählte Wert von $f_s$ (1,8 MHz) erreicht diesen theoretischen Wert ($f_T/2 = 2,5$ MHz) zwar nicht, erlaubt aber mit relativ geringem Filteraufwand, die Grundlinie $f_s$ sowie die anderen Seitenlinien, insbesondere die untere Seitenlinie der zweiten Harmonischen, ausreichend zu unterdrücken.

An sich beeinflussen die Grundlinien und die anderen Seitenlinien aufgrund ihres relativ großen Frequenzabstandes die Kernspins im Untersuchungsbereich nicht. Sie werden jedoch vom Verstärker 16 verstärkt und vergrößern dessen Verlustleistung, ohne daß dadurch die diagnostisch relevante Information verbessert wird. Dem Digital-Analog-Wandler 14 ist daher ein auf das obere Seitenband S0 der Taktfrequenz $f_T$ abgestimmtes Bandpaßfilter 15 nachgeschaltet, das die normalerweise unterdrückte Seitenlinie S0 durchläßt und die üblicherweise als Analogsignal verwendete Grundlinie sowie alle anderen Seitenlinien unterdrückt. Das Ausgangssignal des Filters wird von dem Leistungsverstärker 16 verstärkt und der Spule 5 (Fig. 1) zugeführt.

**Patentansprüche**

1. Schaltungsanordnung zur Erzeugung von Hochfrequenzsignalen für Kernspinuntersuchungen, mit einem Festwertspeicher (11), in dem ein sinusförmiges Signal als Folge von Datenworten gespeichert ist, einem Adressengenerator (10) zum Auslesen von Datenworten aus dem Festwertspeicher mit einer Taktfrequenz und einem dem Festwertspeicher nachgeschalteten Digital-Analog-Wandler (14),
dadurch gekennzeichnet, daß die Frequenz des aus dem Speicher ausgelesenen Signals und die Taktfrequenz solche Werte haben, daß das Ausgangssignalspektrum der Schaltungsanordnung eine Hochfrequenzkomponente ($S_0$) mit der für die Kernspinuntersuchung benötigten Larmorfrequenz ($f_L$) enthält.

2. Schaltungsanordnung nach Anspruch 1, dadurch gekennzeichnet, daß die Taktfrequenz $f_T$ und die Frequenz des aus dem Festwertspeicher ausgelesenen Signals $f_s$ so gewählt sind, daß die Beziehung gilt:

$$f_L = nf_T + af_s,$$

wobei n eine positive ganze Zahl größer als Null ist und wobei a den Wert +1 oder -1 hat.

3. Schaltungsanordnung nach Anspruch 1 oder 2, dadurch gekennzeichnet, daß der Adressengenerator (10) eine Zählanordnung (101, 102) enthält, deren Zählstand mit der Taktfrequenz jeweils um einen vorgebbaren Betrag änderbar ist, daß die Zählkapazität der Zählanordnung mehrfach so groß ist wie die Zahl der adressierbaren Speicherplätze im Festwertspeicher (11) und daß das Adreßsignal für den Festwertspeicher aus den Binärstellen eines Ausschnittes des Ausgangssignals der Zählanordnung abgeleitet wird.

4. Schaltungsanordnung nach einem der vorhergehenden Ansprüche, dadurch gekennzeichnet, daß der Adressengenerator eine Zählanordnung (101, 102) enthält, deren Zählstand mit der Taktfrequenz um einen vorgebbaren Betrag änderbar ist und daß zwischen der Zählanordnung und dem Festwertspeicher (11) eine Multiplizierschaltung (103) vorgesehen ist, in der der Zählstand jeweils mit einem vorgebbaren Faktor (f(t)) multipliziert wird.

5. Schaltungsanordnung nach Anspruch 1 bis 4, dadurch gekennzeichnet, daß zwischen dem Festwertspeicher (11) und dem Digital-Analog-Wandler (14) eine Multiplizierschaltung (12) vorgesehen ist, die die aus dem Festwertspeicher ausgelesenen Datenworte mit einem vorgebbaren Faktor (a(t)) multipliziert.

6. Schaltungsanordnung nach einem der vorhergehenden Ansprüche, dadurch gekennzeichnet, daß der Adressengenerator als letzte Stufe eine Addierschaltung (105) enthält.

7. Schaltungsanordnung nach einem der vorhergehenden Ansprüche, dadurch gekennzeichnet, daß die Zählschaltung eine Addierschaltung (101) enthält, deren Ausgang über einen Speicher (102) mit einem Eingang der Addierschaltung verbunden ist und daß an einem zweiten Eingang der Addierschaltung ein konstanter Wert anliegt.

**Claims**

1. A circuit arrangement for generating rf signals for MR examinations, comprising a read-only memory (11) in which a sinusoidal signal is stored as a series of data words, an address generator (10) for reading data words from the read-only memory at a clock frequency, and a digital-to-analog converter (14) which succeeds the read-only memory, characterized in that the frequency of the signal read from the memory and the clock frequency have values such that the output spectrum of the circuit arrangement contains a high-frequency component ($S_o$) having the Larmor frequency $f_L$ required for the MR examination.

2. A circuit arrangement as claimed in Claim 1, characterized in that the dock frequency $f_T$ and the frequency $f_s$ of the signal read from the read-only memory are chosen so that:

$$f_L = nf_T + af_s$$

where n is a positive integer larger than zero and a has the value +1 or -1.

3. A circuit arrangement as claimed in Claim 1 or 2, characterized in that the address generator (10) comprises a counting device (101, 102) whose count can be changed by a presettable amount with the clock frequency, the counting capacity of the counting device being a multiple of the number of addressable memory locations in the read-only memory (11), the address signal for the read-only memory being derived from the bit positions of a part of the output signal of the counting device.

4. A circuit arrangement as claimed in any one of the preceding Claims, characterized in that the address generator comprises a counting device (101, 102) whose count can be varied by a presettable amount with the clock frequency, between the counting device and the read-only memory (11) there being connected a multiplier circuit (103) in which the count is each time multiplied by a presettable factor (f(t)).

5. A circuit arrangement as claimed in the Claims 1 to 4, characterized in that between the read-only memory (11) and the digital-to-analog converter (14) there is connected a multiplier circuit (12) which multiplies the data words read from the read-only memory by a presettable factor (a(t)).

6. A circuit arrangement as claimed in any one of the preceding Claims, characterized in that the last stage of the address generator is formed by an adding circuit (105).

7. A circuit arrangement as claimed in any one of the preceding Claims, characterized in that the counting circuit comprises an adding circuit (101) whose output is connected, via a memory (102), to one input of the adding circuit, a constant value being present on a second input of the adding circuit.

**Revendications**

1. Montage de circuit pour la production de signaux de haute fréquence destinés à des examens par résonance de spin nucléaire comportant une mémoire morte (11) dans laquelle est stocké un signal sinusoïdal sous la forme d'une séquence de mots de donnees, un générateur d'adresses (10) pour l'extraction de mots de données de la mémoire morte à une fréquence de récurrence et un convertisseur numérique/analogique (14) monté en aval de la mémoire morte, caractérisé en ce que la fréquence du signal extrait de la mémoire et la fréquence de recurrence ont des valeurs telles que le spectre de signal de sortie du montage de circuit contienne une composante de haute fréquence ($S_o$) à la fréquence de Larmor ($f_L$) nécessaire pour l'examen par résonance de spin nucléaire.

2. Montage de circuit suivant la revendication 1, caractérisé en ce que la fréquence de recurrence ($f_T$) et la fréquence ($f_S$) du signal extrait de la mémoire morte sont choisies pour répondre à la relation :

$$f_L = nf_T + af_s,$$

où n est un nombre entier positif supérieur à zéro et présente la valeur +1 ou -1.

3. Montage de circuit suivant la revendication 1 ou 2, caractérisé en ce que le générateur d'adresses (10) contient un dispositif de comptage (101, 102) dont l'état de comptage peut être modifié chaque fois d'une valeur absolue pouvant être prédéterminée au moyen de la fréquence de récurrence, que la capacité de comptage du dispositif de comptage vaut plusieurs fois le nombre d'emplacements de mémoire adressables de la mémoire morte et que le signal d'adresse pour la mémoire morte est dérivé des emplacements binaires d'une section du signal de sortie du dispositif de comptage.

4. Montage de circuit suivant l'une quelconque des revendications précédentes, caractérisé en ce que le générateur d'adresses contient un dispositif de comptage (101, 102) dont l'état de comptage peut être modifié d'une valeur absolue pouvant être prédéterminée au moyen de la fréquence de recurrence et qu'entre le dispositif de comptage et la mémoire morte (11), est prévu un circuit multiplicateur (103) dans lequel l'état de comptage est chaque fois multiplié par un facteur ($f_T$) pouvant être prédéterminé.

5. Montage de circuit suivant les revendications 1 à 4, caractérisé en ce qu'entre la mémoire morte (11) et le convertisseur numérique/analogique (14) est prévu un circuit multiplicateur (12) qui multiplie les mots de données extraits de la mémoire morte par un facteur (a(t)) pouvant être prédéterminé.

6. Montage de circuit suivant l'une quelconque des revendications précédentes, caractérisé en ce que le générateur d'adresses contient, en tant que dernier étage, un circuit additionneur (105).

7. Montage de circuit suivant l'une quelconque des revendications précédentes, caractérisé en ce que le circuit de comptage contient un circuit additionneur (101) dont la sortie est connectée par l'intermédiaire d'une mémoire (102) à une entrée du circuit additionneur et qu'à une deuxième entrée du circuit additionneur est présente une valeur constante.

Fig.1

Fig.2

Fig.3

Fig.4

Fig.5